# EUROPÄISCHE PATENTANMELDUNG

(11) **EP 1 655 678 A1**
(43) Veröffentlichungstag der Anmeldung: **10.05.2006**
(21) Anmeldenummer: 05015192.7
(22) Anmeldetag: 13.07.2005
(51) Int. Cl.: G06F 17/50, G06F 17/30

(54) **Verfahren zum abrufbaren Speichern von Audiodaten in einer Computervorrichtung**

(30) Priorität: 21.07.2004 DE 102004035244
(71) Anmelder: GiveMePower GmbH, 10709 Berlin (DE)
(72) Erfinder: Gräbert, Robert, 14193 Berlin (DE)
(74) Vertreter: Bittner, Thomas L.

(57) **Zusammenfassung**

Die Erfindung bezieht sich auf ein Verfahren zum abrufbaren Speichern von Audiodaten in einer Computervorrichtung, auf der ein CAD-Anwendungsprogramm ausführbar installiert ist. Bei dem Verfahren wird eine Spracheingabe des Benutzers mit Hilfe erzeugter Audiodaten in einer Speichereinrichtung der Computervorrichtung gespeichert. Die Audiodaten werden mit Hilfe einer elektronischen Zuordnung einem ausgewählten Punkt in einer CAD-Zeichnung zugeordnet, so daß die gespeicherten Audiodaten bei einer späteren Markierung des ausgewählten Punktes mit Hilfe eines Spracheingabe-Anwendungsteilprogrammes abrufbar sind.

## Beschreibung

Die Erfindung betrifft ein Verfahren zum abrufbaren Speichern von Audiodaten in einer Computervorrichtung, auf der ein CAD-Anwendungsprogramm (CAD - "Computer Aided Design") ausführbar installiert ist.

CAD-Anwendungsprogramme werden genutzt, um Zeichnungen beliebiger Art computergestützt zu verarbeiten. Die Zeichnungen können mittels des genutzten CAD-Anwendungsprogramms in beliebiger Art und Weise bearbeitet werden. Zu den Bearbeitungsschritten gehört beispielsweise das Erzeugen neuer Zeichnungen, das Verändern vorhandener Zeichnungen oder auch das Vervielfältigen von Zeichnungen. CAD-Anwendungsprogramme werden in verschiedensten Bereichen der Technik genutzt, beispielsweise in Verbindung mit Architekten-Zeichnungen oder Maschinenbauzeichnungen.

Aufgabe der Erfindung ist es, die Nutzungsmöglichkeiten eines CAD-Anwendungsprogrammes zu erweitern und die Bedienungsfreundlichkeit für den Benutzer des CAD-Anwendungsprogrammes zu verbessern.

Diese Aufgabe wird erfindungsgemäß durch ein Verfahren nach dem unabhängigen Anspruch 1 gelöst.

Erfindungsgemäß ist ein Verfahren zum abrufbaren Speichern von Audiodaten in einer Computervorrichtung geschaffen, auf der ein CAD-Anwendungsprogramm ausführbar installiert ist, wobei das Verfahren die folgenden Schritte umfaßt:
- Darstellen einer Zeichnung mit Zeichnungselementen innerhalb einer Zeichenfläche auf einer von der Computervorrichtung umfaßten Bildschirmfläche beim Ausführen des CAD-Anwendungsprogramms;
- Erfassen einer Auswahl eines auf der Computervorrichtung installierten Audio-Anwendungsteilprogramms des Benutzers durch die Steuereinrichtung;
- Ausgeben einer Spracheingabemaske über die Bildschirmfläche im Rahmen des Audio-Anwendungsteilprogramms;
- Erfassen einer Markierung eines von einem Benutzer mittels einer von der Computervorrichtung umfaßten Eingabeeinrichtung ausgewählten Punktes, dessen Lage auf der Zeichenfläche mittels zugehöriger Koordinatendaten definiert ist, auf oder benachbart zu den Zeichnungselementen mit Hilfe einer von der Computervorrichtung umfaßten Steuereinrichtung;
- Erzeugen von Audiodaten mit Hilfe des Audio-Anwendungsteilprogramms entsprechend einer Spracheingabe, welche mittels einer von der Computervorrichtung umfaßten Mikrofoneinrichtung erfaßt wird; und
- Speichern der Audiodaten in einer von der Computervorrichtung umfaßten Speichereinrichtung sowie einer elektronischen Zuordnung zwischen den Audiodaten und dem mittels zugehöriger Koordinatendaten definierten und ausgewählten Punkt, so daß die Audiodaten bei einer erneuten Markierung des ausgewählten Punktes mittels des Audio-Anwendungsteilprogramms wiedergegeben werden können.

Das vorgeschlagene Verfahren stellt dem Benutzer des CAD-Anwendungsprogramms die Möglichkeit zur Verfügung, beliebige Zusatzinformationen als Audiodaten im Zusammenhang mit einem Zeichnungselement aus der bearbeiteten Zeichnung in der Computervorrichtung zu speichern. Während in Verbindung mit der Nutzung eines üblichen CAD-Anwendungsprogramms nur die Zeichnungselemente als Information über den gezeichneten Gegenstand elektronisch gespeichert werden, kann der Benutzer mit Hilfe des vorgeschlagenen Verfahrens Zusatzinformationen zu Zeichnungselementen so speichern, daß die Zusatzinformation Punkten und/oder Zeichnungselementen der mit dem CAD-Anwendungsprogramms bearbeiteten Zeichnung zugeordnet ist. Dieses ist beispielsweise in einer Situation von Vorteil, wenn ein Architekt auf einer Baustelle mit Hilfe des CAD-Anwendungsprogramms auf der Computervorrichtung Grundrisse von Räumen oder Gebäuden zeichnet. Mittels der Spracheingabe kann der Architekt in diesem Fall Zusatzinformationen betreffend die Räume/Gebäude zu einzelnen Zeichnungselementen, beispielsweise einer gezeichneten Wand, elektronisch speichern, zum Bauspiel Angaben über den baulichen Zustand von Wänden. Ein Zeichnungselement der CAD-Zeichnung, zu dem Audiodaten gespeichert werden, kann hier auch ein leerer Zeichnungsabschnitt in der Zeichenfläche sein, wenn es sich beispielsweise um die Umgebung eines Gebäudes geht, über die Zusatzinformation in Form von Audiodaten gespeichert wird. Wenn der Architekt dann zu einem späteren Zeitpunkt im Büro einen Bericht über die Besichtigung verfaßt, kann er auf die gespeicherten Audiodaten zurückgreifen, die ihrerseits Punkten und/oder Zeichnungselementen der auf der Baustelle erzeugten CAD-Zeichnung zugeordnet sind.

Ein weiterer Vorteil des geschaffenen Verfahrens besteht darin, daß die Bedienungsfreundlichkeit für den Benutzer des CAD-Anwendungsprogrammes verbessert wird. Für den Benutzer ist es nicht länger notwendig, neben der Computervorrichtung mit dem CAD-Anwendungsprogramm ein Diktiergerät zum Aufnehmen von Sprachinformationen zu benutzen. Während einer solchen Sprachaufnahme muß der Benutzer in geeigneter Weise dafür sorgen, daß die Zeichnung in dem CAD-Anwendungsprogramm und die Spracheingaben auf dem Diktiergerät miteinander korreliert werden, beispielsweise indem zu jeder Spracheingabe eine Information über das zugehörige Zeichnungselement diktiert wird. Dieser Aufwand entfällt.

Eine zweckmäßige Ausgestaltung der Erfinder sieht vor, daß ein graphisches Audiodaten-Symbol erzeugt und benachbart zu dem ausgewählten Punkt auf der Zeichenfläche dargestellt wird, welches angezeigt, daß dem ausgewählten Punkt zugeordnete Audiodaten gespeichert sind. Hierdurch wird dem Benutzer einerseits bei dem Darstellen der Zeichnung auf der Bildschirmfläche sofort angezeigt, zu welchen Zeichnungselementen Audiodaten existieren. Des weiteren erleichtert das Audiodaten-Symbol dem Benutzer eine Markierung, wenn die zugehörigen Audiodaten wiedergegeben werden soll.

Eine bevorzugte Weiterbildung der Erfindung kann vorsehen, daß die Audiodaten über eine von der Computervorrichtung umfaßten Lautsprechereinrichtung wiedergegeben werden, nach dem eine erneute Auswahl des Audio-Anwendungsteilprogrammes und eine erneute Markierung des ausgewählten Punktes durch den Benutzer mittels der Steuereinrichtung erfaßt werden.

Eine vorteilhafte Ausführungsform der Erfindung sieht vor, daß mit der Spracheingabe-Funktionsmaske ein vom Benutzer editierbares Texteingabefeld über die Bildschirmfläche ausgegeben, eine Texteingabe erfaßt, Textdaten entsprechend der Texteingabe erzeugt und in der Speichereinrichtung gespeichert werden, wobei darüber hinaus eine weitere elektronische Zuordnung zwischen den Textdaten und dem mittels zugehöriger Koordinatendaten definierten und ausgewählten Punkt erzeugt und gespeichert wird.

Auf diese Weise wird es dem Benutzer ermöglicht, neben der Sprachinformation zusätzlich einen Text zu dem ausgewählten Punkt in der Zeichnung zu speichern, so daß der Text nach erneuter Markierung des ausgewählten Punktes auf der Bildschirmfläche als Zusatzinformation zu dem ausgewählten Punkt ausgegeben werden kann.

Eine Weiterbildung der Erfindung kann vorsehen, daß als elektronische Zuordnung und/oder weitere elektronische Zuordnung eine Attributenzuordnung zu dem ausgewählten Punkt erzeugt und gespeichert wird.

Die Audiodaten und/ oder die Textdaten werden bevorzugt als EED-Zusatz (EED - "Extended Entity Data") zu dem ausgewählten Punkt gespeichert.

Die Erfindung wird im folgenden anhand eines Ausführungsbeispiels unter Bezugnahme auf eine Zeichnung näher erläutert. Hierbei zeigen:
- Fig. 1: eine schematische Darstellung einer Computervorrichtung zur Nutzung eines CAD-Anwendungsprogrammes;
- Fig. 2: ein Ablaufdiagramm zur Erläuterung eines Verfahrens zum abrufbaren Speichern von Audiodaten in der Computervorrichtung nach Fig. 1;
- Fig. 3A - 3D: Bildschirmdarstellungen auf einer Bildschirmeinrichtung der Computervorrichtung nach Fig. 1 im Verlauf des Verfahrens zum abrufbaren Speichern von Audiodaten; und
- Fig. 4: eine schematische Darstellung zur Erläuterung des Speicherns von Audiodaten zu einem Zeichnungsobjekt.

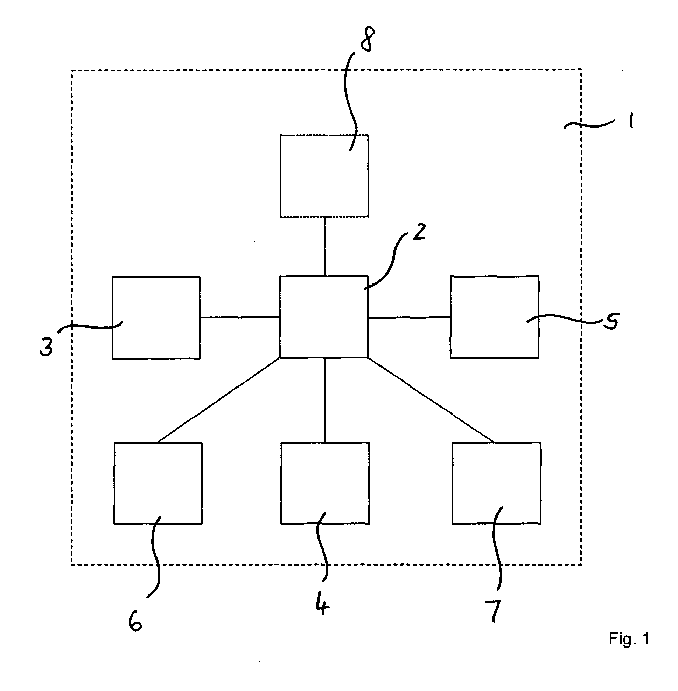

Fig. 1 zeigt eine schematische Darstellung einer Computervorrichtung 1 mit einer Steuereinrichtung 2, die mit einer Speichereinrichtung 3, einer Eingabeeinrichtung 4 sowie einen Bildschirm 5 verbunden ist. Mit Hilfe der Steuereinrichtung 2, die üblicherweise Prozessormittel und einen Arbeitsspeicher umfaßt, beispielsweise die für Computer übliche zentrale Verarbeitungseinheit, werden die Prozesse, die beim Ausführen von Software-Anwendungsprogrammen auf der Computervorrichtung ablaufen, koordiniert. Dieses betrifft insbesondere den Austausch elektronischer Daten zwischen der Speichereinrichtung 3, der Eingabeeinrichtung 4, bei der es sich um eine Maus und/oder eine Tastatur handeln kann, sowie dem Bildschirm 5. Die Computervorrichtung 1 umfaßt weiterhin ein Mikrophon 6 sowie einen Lautsprecher 7. Darüber hinaus können weitere Komponenten angeschlossen sein, beispielsweise ein auswechselbarer Speicher 8. Bei der Computervorrichtung 1 kann es sich um ein tragbares Gerät handeln, zum Beispiel einen Taschencomputer. Alternativ kann die Computervorrichtung 1 auch als sogenannter Desktop-Computer ausgeführt sein.

Auf der Computervorrichtung 1 ist ein CAD-Anwendungsprogramm (CAD - "Computer Aided Design") installiert, mit dem Zeichnungen auf Basis elektronischer Daten erzeugt und bearbeitet werden können, wie dieses für derartige Programme allgemein bekannt ist.

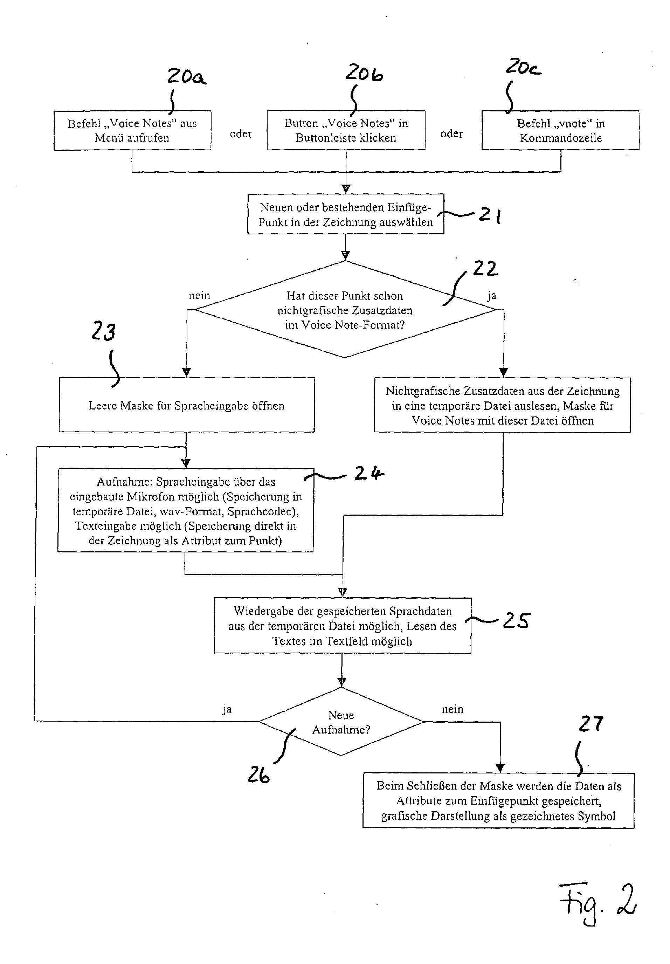

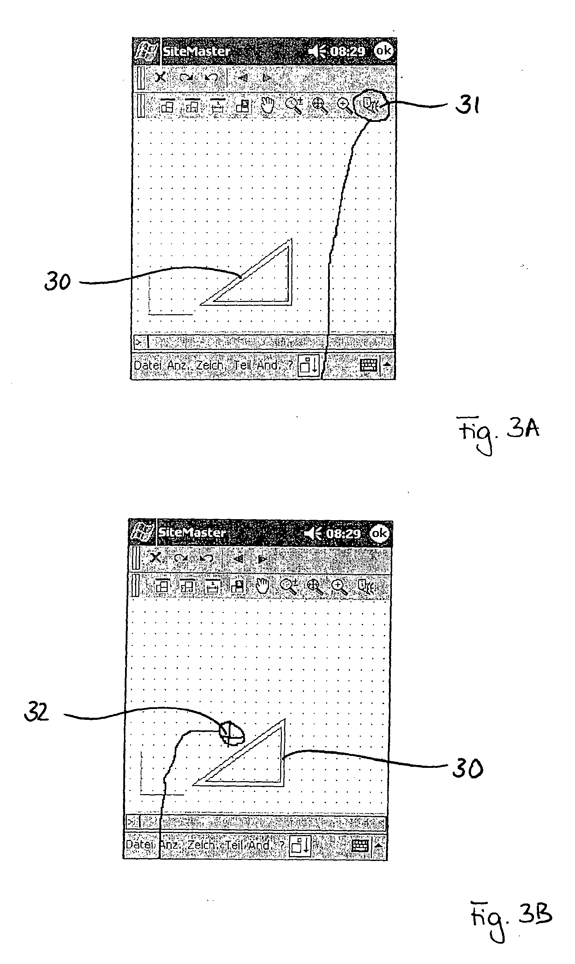

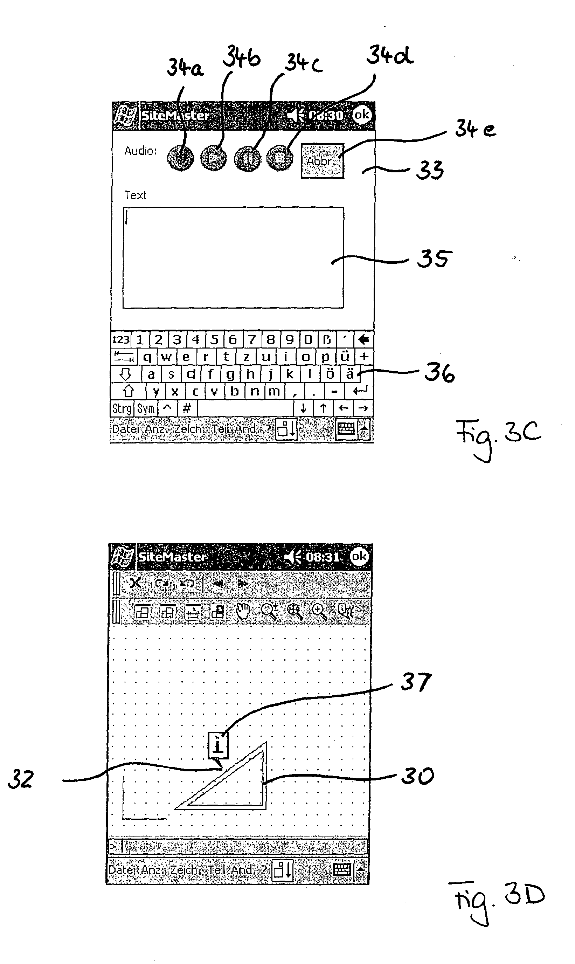

Im folgenden wird ein Verfahren zum abrufbaren Speichern von Audiodaten in der Computervorrichtung 1 unter Bezugnahme auf die Fig. 2 sowie 3A - 3D näher beschrieben. Fig. 2 zeigt ein Ablaufdiagramm zur Erläuterung des Verfahrens. Die Fig. 3A - 3D zeigen verschiedene Bildschirmdarstellungen, die im Verlauf des Verfahrens auf einer Bildschirmfläche des Bildschirms 5 dem Benutzer der Computervorrichtung 1 dargestellt werden.

Nach dem Start des auf der Computervorrichtung 1 installierten CAD-Anwendungsprogramms wird von dem Benutzer mit Hilfe der zur Verfügung stehenden Funktionselemente des CAD-Anwendungsprogramms ein Gegenstand 30 gezeichnet, wie dies bei der Fig. 3A dargestellt ist. Möchte der Benutzer nun zu dem gezeichneten Gegenstand 30 Zusatzinformation in Form einer Sprachnachricht elektronisch speichern, wählt er mit Hilfe der Eingabeeinrichtung 4 ein Audio-Anwendungsteilprogramm "Voice Notes" aus 20a, 20b, 20c (vgl. Fig. 2). Dieses geschieht bei dem dargestellten Beispiel in den Fig. 3A - 3D, indem ein Button 31 betätigt wird. Weiterhin markiert der Benutzer gemäß der Erwartung des Audio-Anwendungsteilprogramms einen ausgewählten Punkt 32 in der Zeichnung, dem die aufzunehmende Spracheingabe zugeordnet werden soll 21. Der ausgewählte Punkt 32 liegt, wie in Fig. 3B gezeigt, neben dem gezeichneten Gegenstand 30. Es kann aber auch ein Punkt mittels Markierung ausgewählt werden, der auf einem Abschnitt des gezeichneten Gegenstandes 30 liegt. Hinsichtlich des Ablaufs beim Erfassen und Speichern der Spracheingabe kann auch vorgesehen sein, daß zunächst der ausgewählte Punkt 32 markiert wird und anschließend das Audio-Anwendungsteilprogramm aufgerufen wird.

Die Steuereinrichtung 2 prüft nach dem Erfassen der Auswahl des Audio-Anwendungsteilprogramms und dem Markieren des ausgewählten Punktes 32 durch den Benutzer, ob zu dem ausgewählten Punkt 32 bereits gespeicherte Audiodaten in der Speichereinrichtung 3 gespeichert sind 22. Falls bereits gespeicherte Audiodaten vorhanden sind, wird dies dem Benutzer dadurch angezeigt, daß auf dem Bildschirm 5 die Wiedergabe-/Aufzeinungslänge der Audiodaten angezeigt wird. Wenn dieses nicht der Fall ist, wird im Rahmen des CAD-Anwendungsprogrammes über den Bildschirm 5 eine Spracheingabemaske 33 ausgegeben 23, wie dies in Fig. 3C gezeigt ist. Die Spracheingabemaske 33 umfaßt Funktionselemente 34a - 34e, wie sie in Verbindung mit Spracheingabe/-wiedergabe-Programmen oder auch an Sprachaufzeichnungsgeräten als Bedienfelder bekannt sind. Der Benutzer kann mit Hilfe der Eingabeeinrichtung 4 die Funktionselemente 34a - 34e bedienen, um eine Spracheingabe aufzunehmen 24. Hierbei wird das Mikrophon 6 zum Erfassen der Spracheingabe genutzt.

Gemäß Fig. 3D wird in der Spracheingabemaske 33 zusätzlich ein editierbares Texteingabefeld 35 dem Benutzer über den Bildschirm 5 zur Verfügung gestellt. Unter Benutzung einer ebenfalls dargestellten Bildschirmtastatur 36 oder mit Hilfe der Eingabeeinrichtung 4 kann der Benutzer einen Text eingeben, welcher Zusatzinformationen zu dem ausgewählten Punkt 32 umfaßt.

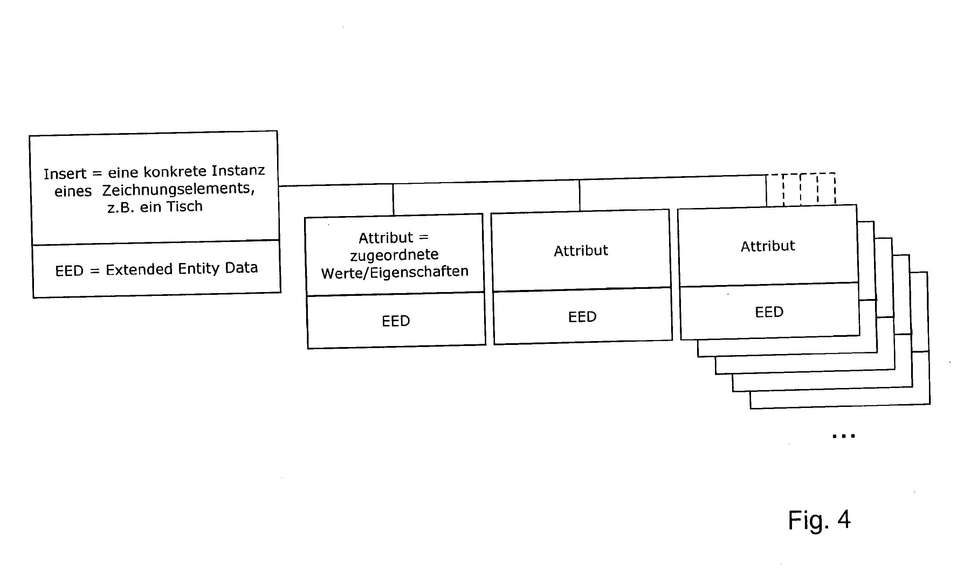

Nach dem Aufzeichnen der Spracheingabe und/oder dem Erfassen der Texteingabe werden zugehörige Audiodaten/Textdaten in der Speichereinrichtung 3 als dem ausgewählten Punkt 32 zugehörig gespeichert 25. Aufgezeichnete Audiodaten werden in dem dargestellten Ausführungsbeispiel im EED-Format (EED - "Extended Entity Data") als Attribut zum betreffenden Zeichnungselement gespeichert, wie dies in Fig. 4 schematisch dargestellt ist. EED können grundsätzlich beliebig groß. In bestimmten CAD-Umgebungen werden sie aber auf 16 kByte beschränkt. Aus Kompatibilitätsgründen werden die Audiodaten auf 16 kByte große Blöcke aufgeteilt und in EED verpackt. EED dienen als eine Art Container. Auf diese Weise können zu einem Insert beliebig große Anhänge gespeichert werden.

Gemäß Fig. 3D wird im Bereich des ausgewählten Punktes 32 nach dem Speichern der Audiodaten und/oder der Textdaten ein graphisches Symbol 37 in der Zeichnung dargestellt. Bei einer späteren erneuten Markierung des ausgewählten Punktes 32, beispielsweise mittels einer Auswahl des graphischen Symbols 37, und des Audio-Anwendungsteilprogramms können die gespeicherten Audiodaten über den Lautsprecher 7 ausgegeben werden. Falls zu dem ausgewählten Punkt 32 gespeicherte Textdaten existieren, werden diese in dem Texteingabefeld 34 dargestellt.

Das dann aktivierte Audio-Anwendungsteilprogramm ermöglicht dem Benutzer eine neue Aufnahme einer Spracheingabe 26. Falls dieses nicht gewünscht ist, wird die Spracheingabemaske 33 geschlossen 27.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Verfahren zum abrufbaren Speichern von Audiodaten in einer Computervorrichtung (1), auf der ein CAD-Anwendungsprogramm ausführbar installiert ist, wobei das Verfahren die folgenden Schritte umfaßt:
- Darstellen einer Zeichnung mit Zeichnungselementen (30) innerhalb einer Zeichenfläche auf einer von der Computervorrichtung (1) umfaßten Bildschirmfläche beim Ausführen des CAD-Anwendungsprogramms;
- Erfassen einer Auswahl eines auf der Computervorrichtung (1) installierten Audio-Anwendungsprogramms des Benutzers durch die Steuereinrichtung (2);
- Ausgeben einer Spracheingabemaske (33) über die Bildschirmfläche im Rahmen des Audio-Anwendungsprogramms;
- Erfassen einer Markierung eines von einem Benutzer mittels einer von der Computervorrichtung (1) umfaßten Eingabeeinrichtung (4) ausgewählten Punktes (32), dessen Lage auf der Zeichenfläche mittels zugehöriger Koordinatendaten definiert ist, auf oder benachbart zu den Zeichnungselementen (30) mit Hilfe einer von der Computervorrichtung (1) umfaßten Steuereinrichtung (2);
- Erzeugen von Audiodaten mit Hilfe des Audio-Anwendungsprogramms entsprechend einer Spracheingabe, welche mittels einer von der Computervorrichtung (1) umfaßten Mikrofoneinrichtung (6) erfaßt wird; und
- Speichern der Audiodaten in einer von der Computervorrichtung (1) umfaßten Speichereinrichtung (3) sowie einer elektronischen Zuordnung zwischen den Audiodaten und dem mittels zugehöriger Koordinatendaten definierten und ausgewählten Punkt (32), so daß die Audiodaten bei einer erneuten Markierung des ausgewählten Punktes (32) mittels des Audio-Anwendungsteilprogramms wiedergegeben werden können.

2. Verfahren nach Anspruch 1, **gekennzeichnet durch** Erzeugen und Darstellen eines grafischen Audiodaten-Symbols (37) im Bereich des ausgewählten Punktes (32) auf der Zeichenfläche, welches anzeigt, daß dem ausgewählten Punkt (32) zugeordnete Audiodaten gespeichert sind.

3. Verfahren nach Anspruch 1 oder 2, **dadurch gekennzeichnet, daß** die Audiodaten über eine von der Computervorrichtung (1) umfaßte Lautsprechereinrichtung (7) wiedergegeben werden, nachdem eine erneute Markierung des ausgewählten Punktes (32) und eine erneute Auswahl des Audio-Anwendungsteilprogramms durch den Benutzer mit Hilfe der Steuereinrichtung (2) erfaßt wurden.

4. Verfahren nach einem der vorangehenden Ansprüche, **dadurch gekennzeichnet, daß** in der Spracheingabemaske (33) ein vom Benutzer editierbares Texteingabefeld (35) über die Bildschirmfläche ausgegeben, eine Texteingabe erfaßt, Textdaten entsprechend der Texteingabe erzeugt und in der Speichereinrichtung (3) gespeichert werden, wobei darüber hinaus eine weitere elektronische Zuordnung zwischen den Textdaten und dem mittels zugehöriger Koordinatendaten definierten und ausgewählten Punkt (32) erzeugt und gespeichert wird.

5. Verfahren nach einem der vorangehenden Ansprüche, **dadurch gekennzeichnet, daß** als elektronische Zuordnung und/oder weitere elektronische Zuordnung eine Attributzuordnung zu dem ausgewählten Punkt (32) erzeugt und gespeichert wird.

6. Verfahren nach einem der vorangehenden Ansprüche, **dadurch gekennzeichnet, daß** die Audiodaten und/oder die Textdaten als EED-Zusatz (EED - "Extended Entity Data") zu dem ausgewählten Punkt (32) gespeichert werden.
